# FASCICULE DE BREVET EUROPEEN

(11) **EP 3 066 525 B1**
(45) Date de publication et mention de la délivrance du brevet: **09.08.2017**
(21) Numéro de dépôt: 14809450.1
(22) Date de dépôt: 03.11.2014
(51) Int. Cl.: G03F 7/20, G01B 21/02, G01N 21/47, G01N 21/95

(54) **SYSTÈME INFORMATIQUE POUR L'EXPLOITATION DE MESURES HÉTÉROGÈNES ISSUES DE DIFFÉRENTS APPAREILS DE MÉTROLOGIE EN VUE DE L'ESTIMATION DE VALEURS DE CARACTÉRISTIQUES DE DISPOSITIFS MICROÉLECTRONIQUES, PROCÉDÉ ET PROGRAMME D'ORDINATEUR CORRESPONDANTS**
COMPUTERSYSTEM ZUR VERARBEITUNG VON HETEROGENEN MESSUNGEN AUS VERSCHIEDENEN METROLOGIEVORRICHTUNGEN IM HINBLICK AUF WERTESCHÄTZUNG VON MERKMALEN MIKROELEKTRONISCHER VORRICHTUNGEN, ENTSPRECHENDES VERFAHREN UND COMPUTERPROGRAMM
COMPUTER SYSTEM FOR PROCESSING HETEROGENEOUS MEASUREMENTS FROM VARIOUS METROLOGY APPARATUSES WITH A VIEW TO ESTIMATING VALUES OF FEATURES OF MICROELECTRONIC DEVICES, CORRESPONDING METHOD AND COMPUTER PROGRAM

(30) Priorité: 07.11.2013 FR 1360894
(43) Date de publication de la demande: 14.09.2016
(73) Titulaire: Commissariat à l'Énergie Atomique et aux Énergies Alternatives, 75015 Paris (FR)
(72) Inventeur: HAZART, Jérôme, 38320 Eybens (FR); FOUCHER, Johann, 38340 Voreppe (FR)
(74) Mandataire: Bonnet, Michel
(86) Numéro de dépôt international: PCT/FR2014/052784
(87) Numéro de publication internationale: WO 2015/067879

(56) Documents cités:
- US-A1- 2013 208 973
- VAID ALOK ET AL: "A holistic metrology approach: hybrid metrology utilizing scatterometry, CD-AFM, and CD-SEM", METROLOGY, INSPECTION, AND PROCESS CONTROL FOR MICROLITHOGRAPHY XXV, SPIE, 1000 20TH ST. BELLINGHAM WA 98225-6705 USA, vol. 7971, no. 1, 17 mars 2011 (2011-03-17), pages 1-20, XP060009287, DOI: 10.1117/12.881632

## Description

La présente invention concerne un système informatique pour l'exploitation de mesures hétérogènes issues de différents appareils de métrologie en vue de l'estimation de valeurs de caractéristiques de dispositifs microélectroniques. Elle concerne également un procédé et un programme d'ordinateur correspondants.

Les dispositifs microélectroniques présentant de nos jours des motifs de dimensions caractéristiques de plus en plus petites, celles-ci sont de plus en plus difficiles à estimer à l'aide d'équipements de mesure, dits appareils de métrologie, utilisés en limite de précision et très hétérogènes en termes de technologies employées.

Par exemple, lorsqu'il s'agit de mesurer la largeur de quelques nanomètres d'un motif tel qu'une rainure ou languette formée par fonderie dans un dispositif microélectronique, différents appareils de mesure présentant des précisions et rapidités variables peuvent être généralement utilisés :
- un microscope électronique à balayage fournit une image du dispositif de façon rapide mais imprécise,
- un microscope à force atomique fournit une image du dispositif de façon moins rapide mais plus précise,
- la technologie optique, par exemple un appareil de mesure par scatterométrie, ellipsométrie, réflectométrie, spectroscopie ou autre, fournit un spectre précis de façon rapide mais dont l'analyse est complexe.

Il existe en outre des systèmes informatiques aptes à traiter les données brutes de mesure fournies par ces appareils pour fournir le plus précisément possible des valeurs d'estimation des caractéristiques que l'on souhaite mesurer. Il est connu pour cela de modéliser le fonctionnement d'un appareil donné pour un type de motif à caractériser, un tel modèle définissant le calcul donnant la mesure attendue pour une valeur donnée de la caractéristique observée, et d'en déduire une estimation de cette caractéristique par inversion du modèle à l'aide d'une mesure effectivement réalisée. Ce traitement analytique des mesures effectuées par inversion de modèle permet de compenser les effets de l'utilisation d'un appareil en limite de fonctionnement. C'est par exemple le cas en scatterométrie. Dans d'autres cas, il n'existe pas de modèle à proprement parler de l'appareil associé à la structure à mesurer, mais un algorithme de traitement des mesures est défini en partie par des paramètres de traitement qui sont à déterminer en vue d'optimiser ensuite la détermination des caractéristiques de la structure (par exemple un niveau de seuillage d'images obtenues par microscopie électronique servant à l'analyse des contours d'une image). Le modèle est défini dans ces autres cas par les valeurs des paramètres de traitement, qui seront comparées à une connaissance a priori de leurs valeurs probables. Le document US 2013 / 208973 A1 divulgue un système informatique pour l'exploitation de mesures hétérogènes issues de différents appareils de métrologie en vue de l'estimation de valeurs de caractéristiques prédéfinies de dispositifs microélectroniques, comportant un processeur, des moyens de stockage et une plate-forme logicielle constituée de plusieurs modules fonctionnels stockés dans les moyens de stockage et exécutables par le processeur, les moyens de stockage comportant un espace de modélisation des caractéristiques prédéfinies ou de paramètres de traitement des mesures par enregistrement de modèles directs, chaque modèle direct exprimant au moins une partie des mesures hétérogènes en fonction d'au moins une partie des caractéristiques prédéfinies ou paramètres de traitement et de paramètres de modélisation, la plate-forme logicielle comportant un module fonctionnel de calcul de coût, ce module fonctionnel de calcul de coût fournissant en sortie l'estimation d'un coût par comparaison des mesures hétérogènes avec une estimation de ces mesures obtenue à l'aide d'une application des modèles directs à des valeurs des caractéristiques prédéfinies ou paramètres de traitement, la plate-forme logicielle comportant un module fonctionnel solveur, pour une optimisation itérative par le solveur desdites valeurs de caractéristiques prédéfinies ou paramètres de traitement à partir de la sortie du module fonctionnel de calcul de coût et par inversion des modèles directs. Le document Vaid Alok et al. "A holistic metrology approach: hybrid-metrology utilizing scatterometry, CD-AFM and CD-SEM", Metrology, Inspection and Process Control for microlithography XXV, SPIE, vol. 7971, no. 1, 2011, pages 1-20 divulgue un système informatique pour l'exploitation de mesures hétérogènes issues de différents appareils de métrologie. Il n'en demeure pas moins que différents types d'appareils de métrologie employés pour un même dispositif microélectronique fournissent des mesures hétérogènes difficiles à exploiter pour obtenir au final une bonne estimation de certaines caractéristiques de ce dispositif microélectronique que l'on souhaite évaluer.

Il peut ainsi être souhaité de prévoir un système informatique pour l'exploitation de mesures hétérogènes issues de différents appareils de métrologie, en vue de l'estimation de valeurs de caractéristiques prédéfinies de dispositifs microélectroniques, qui permette de s'affranchir d'au moins une partie des problèmes et contraintes précités.

Il est donc proposé un système informatique pour l'exploitation de mesures hétérogènes issues de différents appareils de métrologie en vue de l'estimation de valeurs de caractéristiques prédéfinies de dispositifs microélectroniques, comportant un processeur, des moyens de stockage et une plate-forme logicielle constituée de plusieurs modules fonctionnels stockés dans les moyens de stockage et exécutables par le processeur, dans lequel :
- les moyens de stockage comportent un espace de modélisation des caractéristiques prédéfinies ou de paramètres de traitement des mesures par enregistrement de modèles directs, chaque modèle direct exprimant au moins une partie des mesures hétérogènes en fonction d'au moins une partie des caractéristiques prédéfinies ou paramètres de traitement et de paramètres de modélisation,
- la plate-forme logicielle comporte un module fonctionnel de calcul de coût et une première interface associée dédiée à la sélection d'une fonction de coût parmi une pluralité de fonctions de coût prédéfinies, ce module fonctionnel de calcul de coût fournissant en sortie l'estimation d'un coût par comparaison des mesures hétérogènes avec une estimation de ces mesures obtenue à l'aide d'une application des modèles directs à des valeurs des caractéristiques prédéfinies ou paramètres de traitement,
- la plate-forme logicielle comporte un module fonctionnel solveur et une deuxième interface associée dédiée à la sélection d'un solveur parmi une pluralité de solveurs prédéfinis, pour une optimisation itérative par le solveur desdites valeurs de caractéristiques prédéfinies ou paramètres de traitement à partir de la sortie du module fonctionnel de calcul de coût et par inversion des modèles directs.

Ainsi, en fournissant une plate-forme logicielle capable d'intégrer une pluralité de fonctions de coût sélectionnables et une pluralité de solveurs sélectionnables, pour une même modélisation d'ensemble des caractéristiques ou paramètres à estimer à l'aide de mesures hétérogènes, le système informatique proposé permet d'exploiter une grande diversité de mesures issues d'appareils de métrologie de types très variés en proposant une souplesse dans l'inversion. Il permet aussi de profiter de cette modélisation d'ensemble pour obtenir des valeurs estimées de meilleure précision que ce qui pourrait être obtenu individuellement avec tous les appareils de métrologie disponibles.

De façon optionnelle :
- la plate-forme logicielle comporte en outre un module fonctionnel comparateur et une troisième interface associée dédiée à la sélection d'un comparateur parmi une pluralité de comparateurs prédéfinis, ce module fonctionnel comparateur fournissant en sortie la comparaison des mesures hétérogènes avec l'estimation de ces mesures obtenue à l'aide de l'application des modèles directs aux valeurs de caractéristiques prédéfinies ou paramètres de traitement, et
- le module fonctionnel de calcul de coût est conçu pour fournir l'estimation du coût à partir de la sortie du module fonctionnel comparateur.

De façon optionnelle également :
- l'espace de modélisation comporte l'enregistrement d'un méta-modèle direct exprimant toutes les mesures hétérogènes en fonction de toutes les caractéristiques prédéfinies ou paramètres de traitement et de paramètres de méta-modélisation, et
- la plate-forme logicielle comporte un module fonctionnel de démultiplexage du méta-modèle pour l'obtention desdits modèles directs.

De façon optionnelle également, chaque modèle direct est associé exclusivement à un unique type d'appareil de métrologie.

De façon optionnelle également, des contraintes liant certaines des caractéristiques prédéfinies ou paramètres de traitement entre elles/eux sont enregistrées dans les moyens de stockage et sont destinées à être prises en compte par le module fonctionnel de calcul de coût ou par le module fonctionnel solveur pour l'optimisation desdites valeurs de caractéristiques prédéfinies ou paramètres de traitement.

De façon optionnelle également, plusieurs fonctions de coût sont enregistrées dans les moyens de stockage, parmi lesquelles :
- une fonction somme de distances, par exemple utilisant la norme L1,
- une fonction entropique d'estimation de densité de probabilité par noyau,
- une fonction de type fonction de pénalité de Huber,
- une fonction de coût bicarrée, et
- une fonction de type fonction de coût de Hampel.

De façon optionnelle également, plusieurs solveurs sont enregistrés dans les moyens de stockage, parmi lesquels :
- un solveur de résolution de systèmes d'équations algébriques à au moins une inconnue,
- un solveur de résolution par algorithme génétique,
- un solveur de résolution par recuit simulé,
- un solveur par optimisation locale non linéaire sans contraintes, et
- un solveur par optimisation locale non linéaire avec contraintes.

De façon optionnelle également, les modèles directs sont définis pour exprimer des mesures hétérogènes issues de différents types d'appareils de métrologie parmi lesquelles :
- des mesures issues d'un microscope électronique à balayage ou à transmission,
- des mesures issues d'un microscope à force atomique,
- des mesures obtenues par scatterométrie, ellipsométrie, réflectométrie ou spectroscopie,
- des mesures de réflectivité ou diffraction par rayons X, et
- des mesures issues d'un microscope optique.

Il est également proposé un procédé d'estimation de valeurs de caractéristiques prédéfinies de dispositifs microélectroniques à partir de mesures hétérogènes issues de différents appareils de métrologie, comportant les étapes suivantes :
- modélisation des caractéristiques prédéfinies ou de paramètres de traitement des mesures par enregistrement de modèles directs dans des moyens de stockage, chaque modèle direct exprimant au moins une partie des mesures hétérogènes en fonction d'au moins une partie des caractéristiques prédéfinies ou paramètres de traitement et de paramètres de modélisation,
- réception, par une plate-forme logicielle exécutée par un processeur ayant accès aux moyens de stockage, des mesures hétérogènes,
- sélection, à l'aide d'une première interface dédiée de la plate-forme logicielle, d'une fonction de coût parmi une pluralité de fonctions de coût prédéfinies,
- sélection, à l'aide d'une deuxième interface dédiée de la plate-forme logicielle, d'un solveur parmi une pluralité de solveurs prédéfinis, et
- optimisation itérative de valeurs des caractéristiques prédéfinies ou paramètres de traitement par :
   - estimation, par le processeur et à l'aide de la fonction de coût sélectionnée, d'un coût par comparaison des mesures hétérogènes avec une estimation de ces mesures obtenue à l'aide d'une application des modèles directs auxdites valeurs de caractéristiques prédéfinies ou paramètres de traitement,
   - mise à jour, par le processeur et à l'aide du solveur sélectionné, desdites valeurs de caractéristiques prédéfinies ou paramètres de traitement à partir du coût estimé et par inversion des modèles directs.

Enfin, il est également proposé un programme d'ordinateur téléchargeable depuis un réseau de communication et/ou enregistré sur un support lisible par ordinateur et/ou exécutable par un processeur, comprenant des instructions pour l'exécution des étapes d'un procédé d'estimation de valeurs de caractéristiques prédéfinies de dispositifs microélectroniques selon l'invention, lorsque ledit programme est exécuté sur un ordinateur.

L'invention sera mieux comprise à l'aide de la description qui va suivre, donnée uniquement à titre d'exemple et faite en se référant aux dessins annexés dans lesquels :
- la figure 1 représente schématiquement la structure générale d'un système informatique pour l'exploitation de mesures hétérogènes issues de différents appareils de métrologie en vue de l'estimation de valeurs de caractéristiques prédéfinies de dispositifs microélectroniques, selon un mode de réalisation de l'invention,
- la figure 2 illustre les étapes successives d'un procédé d'estimation de valeurs de caractéristiques prédéfinies de dispositifs microélectroniques mis en oeuvre par le système informatique de la figure 1.

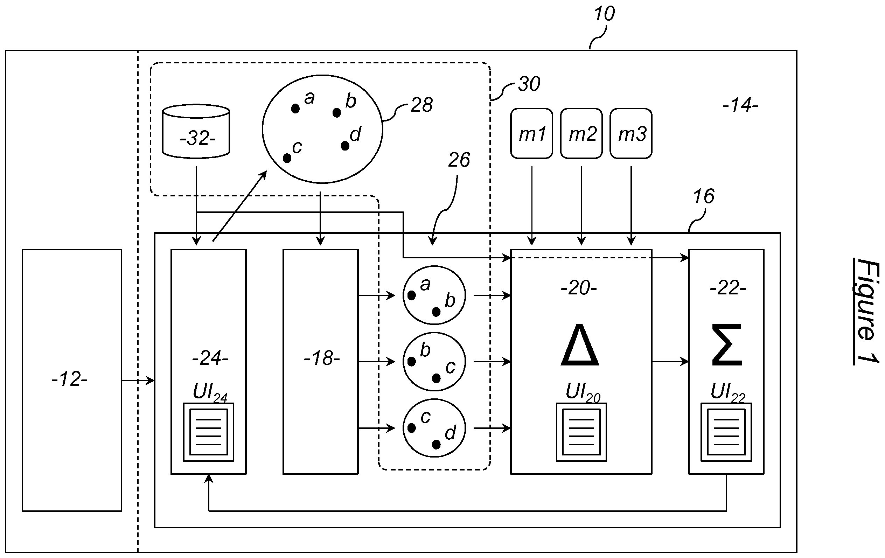

Le système informatique 10 représenté sur la figure 1, par exemple un ordinateur, comporte un processeur 12 associé de façon classique à des moyens de stockage 14, par exemple une mémoire RAM, pour le stockage de fichiers de données et de programmes d'ordinateurs exécutables par le processeur 12.

Parmi les programmes d'ordinateurs exécutables par le processeur 12, une plate-forme logicielle 16 constituée de plusieurs modules fonctionnels 18, 20, 22, 24 est stockée dans la mémoire 14. Le système informatique 10 tel qu'illustré sur la figure 1 comporte ainsi fonctionnellement quatre programmes d'ordinateurs que représentent les modules fonctionnels 18, 20, 22, 24, ou quatre fonctions d'un même programme d'ordinateur que représente la plate-forme logicielle 16. On notera par ailleurs que les modules fonctionnels 18, 20, 22, 24 sont présentés comme distincts, mais cette distinction est purement fonctionnelle. Ils pourraient tout aussi bien être regroupés selon toutes les combinaisons possibles en un ou plusieurs logiciels. Leurs fonctions pourraient aussi être au moins en partie micro programmées ou micro câblées dans des circuits intégrés dédiés. Ainsi, en variante, le système informatique 10 pourrait prendre la forme d'un dispositif électronique composé au moins partiellement de circuits numériques (sans programme d'ordinateur) pour la réalisation des mêmes actions.

Le système informatique 10 est conçu pour l'exploitation de mesures hétérogènes issues de différents appareils de métrologie en vue de l'estimation de valeurs de caractéristiques prédéfinies de dispositifs microélectroniques, cette estimation se faisant éventuellement par l'intermédiaire d'une optimisation de paramètres de traitement des mesures. Dans l'exemple non limitatif illustré sur la figure 1, trois mesures hétérogènes m 1, m2 et m3 sont stockées en mémoire 14 et quatre caractéristiques prédéfinies de dispositifs microélectroniques ou paramètres de traitement des mesures notés a, b, c et d sont à estimer. La mesure m1 est par exemple fournie par un microscope électronique à balayage, la mesure m2 par un microscope à force atomique et la mesure m3 par un appareil de scatterométrie. Chacune de ces mesures pourrait venir d'autres appareils de métrologie tels qu'un microscope électronique à transmission, un appareil de mesure de réflectivité ou diffraction par rayons X, un microscope optique, etc. Les mesures m1, m2, m3 peuvent être des données mono ou multi valuées. Les caractéristiques ou paramètres a, b, c et d, exprimant par exemple des dimensions caractéristiques de motifs de circuits intégrés ou des paramètres de traitement des mesures à déterminer, sont stockés sous la forme de modèles directs 26 ou d'un méta-modèle direct 28 dont ils ou elles constituent les variables, dans un espace de modélisation 30 lui aussi stocké en mémoire 14. Chaque modèle de l'ensemble des modèles directs 26 exprime mathématiquement au moins une partie des mesures hétérogènes m1, m2, m3 en fonction d'au moins une partie des caractéristiques ou paramètres a, b, c, d et de paramètres de modélisation. Cette expression mathématique des mesures m1, m2, m3 en fonction des caractéristiques ou paramètres a, b, c, d peut se faire concrètement par exemple à l'aide de systèmes d'équations, de fonctions probabilistes ou de tirages aléatoires, Le méta-modèle 28, optionnel, représente la somme ou l'union de ces modèles. Enfin, certaines/certains des caractéristiques ou paramètres a, b, c et d peuvent être lié(e)s entre elles/eux par des contraintes 32 également stockées en mémoire 14 dans l'espace de modélisation 30.

Plus précisément, dans un mode de réalisation préféré de l'invention, le méta-modèle direct 28 exprime mathématiquement toutes les mesures hétérogènes m1, m2, m3 en fonction de toutes les caractéristiques prédéfinies ou paramètres a, b, c, d et de paramètres de méta-modélisation. L'espace de modélisation 30 incluant ce méta-modèle 28 peut alors être considéré du point de vue de l'implémentation informatique comme un espace vectoriel dont les dimensions correspondent aux variables a, b, c et d du méta-modèle 28.

Les contraintes 32, liant certaines de ces variables entre elles ou portant sur certaines variables isolément, réduisent éventuellement le nombre de dimensions de l'espace vectoriel. Une contrainte peut par exemple imposer une valeur, ou une plage de valeurs, à une variable. Une autre contrainte peut par exemple imposer une relation, d'égalité ou d'inégalité, linéaire ou pas, entre plusieurs de ces variables. Les contraintes peuvent aussi être exprimées à l'aide de fonctions de coût non liées aux mesures. Ainsi, il peut exister des fonctions de coût associant une valeur à minimiser à certaines variables du méta-modèle 28. Par exemple, si l'on souhaite exprimer le fait que les variables a et b sont presque égales, on peut leur associer une fonction de coût fondée sur la valeur absolue au carré de leur différence. On remarquera qu'une telle fonction de coût peut réaliser un couplage de modèles par pénalités (dans le cas où les variables couplées par la fonction de coût appartiennent à des modèles différents) dont la résolution est connue de l'homme du métier.

Dans ce même mode de réalisation préféré illustré sur la figure 1, le module fonctionnel 18 de la plate-forme logicielle 16 est un module de démultiplexage du méta-modèle 28 pour l'obtention des modèles directs 26, chaque modèle direct étant associé exclusivement à un unique type d'appareil de métrologie, c'est-à-dire à une unique mesure parmi les trois mesures hétérogènes m1, m2 et m3. Un premier modèle direct dont les variables sont les caractéristiques prédéfinies ou paramètres a et b est ainsi par exemple associé à la mesure m1 issue du microscope électronique à balayage à l'aide d'une fonction mathématique f₁ telle que m1 = f₁(a,b,p₁) où p₁ désigne un ensemble de paramètres de ce modèle direct. Un deuxième modèle direct dont les variables sont les caractéristiques prédéfinies ou paramètres b et c est associé à la mesure m2 issue du microscope à force atomique à l'aide d'une fonction mathématique f₂ telle que m2 = f₂(b,c,p₂) où p₂ désigne un ensemble de paramètres de ce modèle direct. Enfin, un troisième modèle direct dont les variables sont les caractéristiques prédéfinies ou paramètres c et d est associé à la mesure m3 issue de l'appareil de scatterométrie à l'aide d'une fonction mathématique f₃ telle que m3 = f₃(c,d,p₃) où p₃ désigne un ensemble de paramètres de ce modèle direct. Les trois modèles directs précités peuvent être considérés comme des sous-espaces vectoriels de l'espace de modélisation 30, extraits à l'aide du module de démultiplexage 18.

Du point de vue de l'implémentation informatique, les données de mesures m1, m2 et m3 sont encapsulées dans des objets. Des observables sont créés pour faire le lien entre ces objets et les modèles directs précités. Ces observables prennent la forme des fonctions mathématiques précitées. Ils consistent à sélectionner les variables des modèles directs auxquels ils sont associés parmi toutes les variables de l'espace de modélisation ; sélectionner les mesures qui leur sont associées ; appliquer les relations définies par les fonctions associées entre les variables et les mesures.

Le module fonctionnel 20 de la plate-forme logicielle 16 est un module comparateur associé à une interface UI₂₀ dédiée à la sélection d'un comparateur parmi une pluralité de comparateurs prédéfinis. Les comparateurs prédéfinis sont par exemple des fonctions de distances ou pseudo-distances point à point définies selon plusieurs normes ou autres fonctions possibles. Par « pseudo-distance », on entend une fonction qui renvoie un poids plus important lorsque les données à comparer sont « éloignées » mais qui ne présente pas nécessairement toutes les propriétés d'une fonction de distance. D'autres fonctions de comparaison peuvent être librement définies et ajoutées par un utilisateur du système informatique 10 dans la liste des comparateurs sélectionnables. Quel que soit le comparateur sélectionné, le module comparateur 20 reçoit en entrée les mesures hétérogènes m1, m2, m3 ainsi qu'une estimation de ces mesures obtenue à l'aide de l'application des modèles directs précités à des valeurs courantes des caractéristiques prédéfinies ou paramètres a, b, c, d. Il fournit en sortie une comparaison point à point des mesures m1, m2, m3 avec leurs estimations respectives. Dans le cas où une partie des contraintes 32 est exprimée à l'aide d'au moins une fonction de coût entre certaines des variables a, b, c, d, le module comparateur 20 compare également les variables concernées entre elles.

Le module fonctionnel 22 de la plate-forme logicielle 16 est un module de calcul de coût associé à une interface UI₂₂ dédiée à la sélection d'une fonction de coût parmi une pluralité de fonctions de coût prédéfinies. Les fonctions de coût prédéfinies sont par exemple des sommes de distances ou pseudo-distances définies selon plusieurs normes (notamment la norme L1 qui permet de définir une fonction de coût robuste) ou autres fonctions possibles. Un autre exemple de fonction de coût est une fonction entropique d'estimation de densité de probabilité par noyau. D'autres fonctions de coût peuvent être librement définies et ajoutées par un utilisateur du système informatique 10 dans la liste des fonctions de coût sélectionnables. Notamment d'autres fonctions de coût robustes telles que la fonction de pénalité de Huber (de l'anglais « Huber Loss Function »), une fonction de coût bicarrée ou la fonction de coût de Hampel peuvent être définies. Quelle que soit la fonction de coût sélectionnée, le module de calcul de coût 22 reçoit en entrée la sortie du module comparateur 20. Il fournit en sortie une estimation d'un coût. Dans le cas où une partie des contraintes 32 est exprimée à l'aide d'au moins une fonction de coût entre certaines des variables a, b, c, d, le module de calcul de coût 22 intègre également cette fonction de coût en supplément de la fonction de coût prédéfinie sélectionnable.

Une distinction a été faite entre le module comparateur 20 et le module de calcul de coût 22, mais en variante un seul module de calcul de coût indifférencié pourrait remplir les deux fonctions précitées.

Le module fonctionnel 24 de la plate-forme logicielle 16 est un module solveur associé à une interface UI₂₄ dédiée à la sélection d'un solveur parmi une pluralité de solveurs prédéfinis. Les solveurs prédéfinis sont par exemple des solveurs de résolution de systèmes d'équations algébriques à au moins une inconnue, des solveurs de résolution par algorithme génétique, des solveurs de résolution par recuit simulé, des solveurs par optimisation locale non linéaire sans contraintes (par exemple Levenberg-Marquardt, Simplex, Newton, quasi-Newton ou « Trust-région »), des solveurs par optimisation locale non linéaire avec contraintes (par exemple « Active set », « Sequential Quadratic Programming », « Trust-région » ou « Interior point »), etc. D'autres solveurs peuvent être librement définis et ajoutés par un utilisateur du système informatique 10 dans la liste des solveurs sélectionnables. Quel que soit le solveur sélectionné, le module solveur 24 reçoit en entrée la sortie du module de calcul de coût 22 ainsi que les contraintes 32 autres que celles exprimées à l'aide de fonctions de coût. A l'aide de ces contraintes 32 et par inversion du méta-modèle direct 28 (ce qui revient à inverser l'ensemble des modèles directs 26), il fournit en sortie une mise à jour des valeurs courantes des caractéristiques prédéfinies ou paramètres a, b, c et d, pour une optimisation itérative de ces valeurs. Il peut alors comporter un testeur apte à appliquer un critère d'arrêt (nombre d'itérations dépassant une certaine limite, variations des valeurs mises à jour inférieures à un certain seuil, coût fourni en sortie du module fonctionnel 22 inférieur à un certain seuil, etc.) dans une boucle d'exécutions successives des modules fonctionnels 18, 20, 22 et 24, pour la fourniture de valeurs définitives de ces caractéristiques prédéfinies ou paramètres de traitement. En variante, dans le cas où c'est la valeur du coût fournie par le module fonctionnel 22 qui est testée, le testeur peut être disposé fonctionnellement entre les modules 22 et 24.

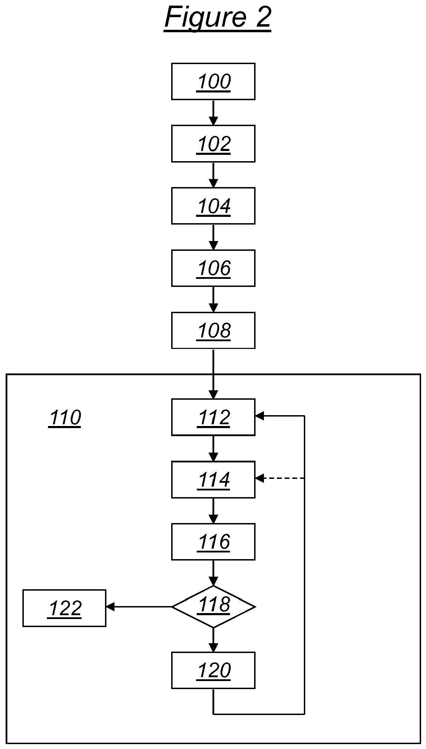

Le fonctionnement du système informatique 10 va maintenant être détaillé en référence à la figure 2, par la mise en oeuvre d'un procédé d'estimation de valeurs de caractéristiques prédéfinies de dispositifs microélectroniques ou de paramètre de traitement de mesures à partir de mesures hétérogènes issues de différents appareils de métrologie.

Au cours d'une première étape d'initialisation 100, le méta-modèle 28 et les contraintes 32 sont enregistrés dans l'espace de modélisation 30 de la mémoire 14.

Au cours d'une étape 102, les mesures hétérogènes m1, m2 et m3 sont enregistrées en mémoire 14 et fournies comme paramètres d'entrée à la plate-forme logicielle 16.

Au cours d'une première étape de sélection 104, un comparateur est sélectionné parmi la pluralité de comparateurs disponibles, à l'aide de l'interface UI₂₀. Au cours d'une deuxième étape de sélection 106, une fonction de coût est sélectionnée parmi la pluralité de fonctions de coût disponibles, à l'aide de l'interface UI₂₂. Enfin, au cours d'une troisième étape de sélection 108, un solveur est sélectionné parmi la pluralité de solveurs disponibles, à l'aide de l'interface UI₂₄.

On notera que l'ordre dans lequel les étapes 100 à 108 peuvent être exécutées est indifférent. Une fois exécutées, ces étapes sont suivies d'une boucle 110 d'étapes qui va maintenant être détaillée.

Au cours d'une première étape 112 de cette boucle d'étapes, réalisée par exécution du module de démultiplexage 18, les modèles directs 26 sont obtenus à partir du méta-modèle 28 avec des valeurs courantes des caractéristiques prédéfinies ou paramètres a, b, c et d (des valeurs initialisées lors de la première itération de la boucle d'étapes 110).

Au cours d'une deuxième étape 114 de cette boucle d'étapes, réalisée par exécution du module comparateur 20, les mesures m1, m2 et m3 sont comparées avec les estimations de ces mesures obtenues à l'aide de l'application des modèles directs 26 aux valeurs courantes des caractéristiques prédéfinies ou paramètres a, b, c et d. Dans le cas où une partie des contraintes 32 est exprimée à l'aide d'au moins une fonction de coût entre certaines des variables a, b, c, d, les variables concernées sont également comparées entre elles.

Au cours d'une troisième étape 116 de cette boucle d'étapes, réalisée par exécution du module de calcul de coût 22, un coût est calculé à partir de la sortie du module fonctionnel comparateur 20. Dans le cas où une partie des contraintes 32 est exprimée à l'aide d'au moins une fonction de coût entre certaines des variables a, b, c, d, le coût calculé à cette étape en tient compte.

Dans un mode de réalisation possible de l'invention, dans lequel la valeur de ce coût est testée pour sortir ou non de la boucle d'étapes 110, la troisième étape 116 est suivie d'une étape de test 118 au cours de laquelle le coût est comparé à un seuil prédéterminé.

Si le coût dépasse ce seuil, le procédé passe à une étape 120 d'exécution du module solveur 24 pour une mise à jour des valeurs courantes des caractéristiques prédéfinies ou paramètres a, b, c et d. L'étape 120 est suivie d'un retour à l'étape 112, ou éventuellement directement à l'étape 114 s'il n'est pas nécessaire de procéder plusieurs fois au démultiplexage du méta-modèle direct 28.

Sinon, le procédé passe à une étape 122 de sortie de la boucle d'étapes 110 et de fin de l'optimisation itérative des valeurs des caractéristiques prédéfinies ou paramètres de traitement.

Il apparaît clairement qu'un système informatique tel que celui décrit précédemment permet d'exploiter une grande diversité de mesures issues d'appareils de métrologie très variés en proposant une souplesse dans l'inversion d'un ensemble de modèles grâce à la sélection possible d'un comparateur, d'une fonction de coût et d'un solveur parmi une pluralité de comparateurs, fonctions de coût et solveurs rendus disponibles par la plate-forme logicielle. Il permet aussi de profiter de cette modélisation d'ensemble pour obtenir des valeurs estimées de meilleure précision que ce qui pourrait être obtenu individuellement pour tous les appareils de métrologie disponibles.

On notera par ailleurs que l'invention n'est pas limitée au mode de réalisation décrit précédemment. Il apparaîtra en effet à l'homme de l'art que diverses modifications peuvent être apportées au mode de réalisation décrit ci-dessus, à la lumière de l'enseignement qui vient de lui être divulgué. Dans les revendications qui suivent, les termes utilisés ne doivent pas être interprétés comme limitant les revendications au mode de réalisation exposé dans la présente description, mais doivent être interprétés pour y inclure tous les équivalents que les revendications visent à couvrir du fait de leur formulation et dont la prévision est à la portée de l'homme de l'art en appliquant ses connaissances générales à la mise en oeuvre de l'enseignement qui vient de lui être divulgué.

## Revendications

1. Système informatique (10) pour l'exploitation de mesures hétérogènes (m1, m2, m3) issues de différents appareils de métrologie en vue de l'estimation de valeurs de caractéristiques prédéfinies (a, b, c, d) de dispositifs microélectroniques, comportant un processeur (12), des moyens de stockage (14) et une plate-forme logicielle (16) constituée de plusieurs modules fonctionnels stockés dans les moyens de stockage et exécutables par le processeur,
- les moyens de stockage (14) comportant un espace (30) de modélisation des caractéristiques prédéfinies ou de paramètres de traitement des mesures (a, b, c, d) par enregistrement de modèles directs (26), chaque modèle direct exprimant au moins une partie des mesures hétérogènes (m1, m2, m3) en fonction d'au moins une partie des caractéristiques prédéfinies ou paramètres de traitement (a, b, c, d) et de paramètres de modélisation,
- la plate-forme logicielle (16) comportant un module fonctionnel (22) de calcul de coût et une première interface associée (UI₂₂) dédiée à la sélection d'une fonction de coût parmi une pluralité de fonctions de coût prédéfinies, ce module fonctionnel de calcul de coût fournissant en sortie l'estimation d'un coût par comparaison des mesures hétérogènes (m1, m2, m3) avec une estimation de ces mesures obtenue à l'aide d'une application des modèles directs (26) à des valeurs des caractéristiques prédéfinies ou paramètres de traitement (a, b, c, d),
- la plate-forme logicielle (16) comportant un module fonctionnel solveur (24) et une deuxième interface associée (UI₂₄) dédiée à la sélection d'un solveur parmi une pluralité de solveurs prédéfinis, pour une optimisation itérative par le solveur desdites valeurs de caractéristiques prédéfinies ou paramètres de traitement (a, b, c, d) à partir de la sortie du module fonctionnel de calcul de coût (22) et par inversion des modèles directs (26).

2. Système informatique (10) selon la revendication 1, dans lequel :
- la plate-forme logicielle (16) comporte en outre un module fonctionnel comparateur (20) et une troisième interface associée (UI₂₀) dédiée à la sélection d'un comparateur parmi une pluralité de comparateurs prédéfinis, ce module fonctionnel comparateur fournissant en sortie la comparaison des mesures hétérogènes (m1, m2, m3) avec l'estimation de ces mesures obtenue à l'aide de l'application des modèles directs aux valeurs de caractéristiques prédéfinies ou paramètres de traitement (a, b, c, d), et
- le module fonctionnel de calcul de coût (22) est conçu pour fournir l'estimation du coût à partir de la sortie du module fonctionnel comparateur (20).

3. Système informatique (10) selon la revendication 1 ou 2, dans lequel :
- l'espace de modélisation (30) comporte l'enregistrement d'un méta-modèle direct (28) exprimant toutes les mesures hétérogènes (m1, m2, m3) en fonction de toutes les caractéristiques prédéfinies ou paramètres de traitement (a, b, c, d) et de paramètres de méta-modélisation, et
- la plate-forme logicielle (16) comporte un module fonctionnel (18) de démultiplexage du méta-modèle (28) pour l'obtention desdits modèles directs (26).

4. Système informatique (10) selon la revendication 3, dans lequel chaque modèle direct est associé exclusivement à un unique type d'appareil de métrologie.

5. Système informatique (10) selon l'une quelconque des revendications 1 à 4, dans lequel des contraintes (32) liant certaines des caractéristiques prédéfinies ou paramètres de traitement (a, b, c, d) entre elles/eux sont enregistrées dans les moyens de stockage (14) et sont destinées à être prises en compte par le module fonctionnel (22) de calcul de coût ou par le module fonctionnel solveur (24) pour l'optimisation desdites valeurs de caractéristiques prédéfinies ou paramètres de traitement.

6. Système informatique (10) selon l'une quelconque des revendications 1 à 5, dans lequel plusieurs fonctions de coût sont enregistrées dans les moyens de stockage (14), parmi lesquelles :
- une fonction somme de distances, par exemple utilisant la norme L1,
- une fonction entropique d'estimation de densité de probabilité par noyau,
- une fonction de type fonction de pénalité de Huber,
- une fonction de coût bicarrée, et
- une fonction de type fonction de coût de Hampel.

7. Système informatique (10) selon l'une quelconque des revendications 1 à 6, dans lequel plusieurs solveurs sont enregistrés dans les moyens de stockage (14), parmi lesquels :
- un solveur de résolution de systèmes d'équations algébriques à au moins une inconnue,
- un solveur de résolution par algorithme génétique,
- un solveur de résolution par recuit simulé,
- un solveur par optimisation locale non linéaire sans contraintes, et
- un solveur par optimisation locale non linéaire avec contraintes.

8. Système informatique (10) selon l'une quelconque des revendications 1 à 7, dans lequel les modèles directs (26) sont définis pour exprimer des mesures hétérogènes issues de différents types d'appareils de métrologie parmi lesquelles :
- des mesures issues d'un microscope électronique à balayage ou à transmission,
- des mesures issues d'un microscope à force atomique,
- des mesures obtenues par scatterométrie, ellipsométrie, réflectométrie ou spectroscopie,
- des mesures de réflectivité ou diffraction par rayons X, et
- des mesures issues d'un microscope optique.

9. Procédé d'estimation de valeurs de caractéristiques prédéfinies (a, b, c, d) de dispositifs microélectroniques à partir de mesures hétérogènes (m1, m2, m3) issues de différents appareils de métrologie, comportant les étapes suivantes :
- modélisation (100) des caractéristiques prédéfinies ou de paramètres de traitement des mesures (a, b, c, d) par enregistrement de modèles directs (26) dans des moyens de stockage (14), chaque modèle direct exprimant au moins une partie des mesures hétérogènes (m1, m2, m3) en fonction d'au moins une partie des caractéristiques prédéfinies ou paramètres de traitement (a, b, c, d) et de paramètres de modélisation,
- réception (102), par une plate-forme logicielle (16) exécutée par un processeur (12) ayant accès aux moyens de stockage (14), des mesures hétérogènes (m1, m2, m3),
- sélection (106), à l'aide d'une première interface dédiée (UI₂₂) de la plate-forme logicielle (16), d'une fonction de coût parmi une pluralité de fonctions de coût prédéfinies,
- sélection (108), à l'aide d'une deuxième interface dédiée (UI₂₄) de la plate-forme logicielle (16), d'un solveur parmi une pluralité de solveurs prédéfinis, et
- optimisation itérative (110) de valeurs des caractéristiques prédéfinies ou paramètres de traitement (a, b, c, d) par :
• estimation (114, 116), par le processeur (12) et à l'aide de la fonction de coût sélectionnée, d'un coût par comparaison des mesures hétérogènes (m1, m2, m3) avec une estimation de ces mesures obtenue à l'aide d'une application des modèles directs (26) auxdites valeurs de caractéristiques prédéfinies ou paramètres de traitement (a, b, c, d),
• mise à jour (120), par le processeur (12) et à l'aide du solveur sélectionné, desdites valeurs de caractéristiques prédéfinies ou paramètres de traitement (a, b, c, d) à partir du coût estimé et par inversion des modèles directs (26).

10. Programme d'ordinateur téléchargeable depuis un réseau de communication et/ou enregistré sur un support lisible par ordinateur et/ou exécutable par le processeur (12), **caractérisé en ce qu'**il comprend des instructions pour l'exécution des étapes d'un procédé d'estimation de valeurs de caractéristiques prédéfinies de dispositifs microélectroniques selon la revendication 9, lorsque ledit programme est exécuté sur un ordinateur.

## Patentansprüche

1. Computersystem (10) zur Verarbeitung von heterogenen Messungen (m1, m2, m3) aus verschiedenen Metrologievorrichtungen im Hinblick auf die Werteschätzung von vordefinierten Merkmalen (a, b, c, d) mikroelektronischer Vorrichtungen, umfassend einen Prozessor (12), Speichermittel (14) und eine Software-Plattform (16), die aus mehreren Funktionsbausteinen aufgebaut ist, die in den Speichermitteln gespeichert und durch den Prozessor ausführbar sind,
- wobei die Speichermittel (14) einen Platz (30) zum Modellieren der vordefinierten Merkmale oder von Bearbeitungsparametern der Messungen (a, b, c, d) durch Aufzeichnen von direkten Modellen (26) umfassen, wobei jedes direkte Modell mindestens einen Teil der heterogenen Messungen (m1, m2, m3) in Abhängigkeit von mindestens einem Teil der vordefinierten Merkmale oder Bearbeitungsparameter (a, b, c, d) und von Modellierungsparametern ausdrückt,
- wobei die Software-Plattform (16) einen Kostenberechnungs-Funktionsbaustein (22) und eine erste assoziierte Schnittstelle (UI₂₂) umfasst, die dem Auswählen einer Kostenfunktion aus einer Vielzahl von vordefinierten Kostenfunktionen dediziert ist, wobei dieser Kostenberechnungs-Funktionsbaustein am Ausgang die Kostenschätzung durch Vergleichen der heterogenen Messungen (m1, m2, m3) mit einer Schätzung dieser Messungen liefert, die mit Hilfe einer Anwendung der direkten Modelle (26) auf Werte der vordefinierten Merkmale oder Bearbeitungsparameter (a, b, c, d) erhalten wurde,
- wobei die Software-Plattform (16) einen Gleichungslöser-Funktionsbaustein (24) und eine zweite assoziierte Schnittstelle (UI₂₄) umfasst, die dem Auswählen eines Gleichungslösers aus einer Vielzahl von vordefinierten Gleichungslösern dediziert ist, für ein iteratives Optimieren, durch den Gleichungslöser, der Werte von vordefinierten Merkmalen oder Bearbeitungsparametern (a, b, c, d) anhand des Ausgangs des Kostenberechnungs-Funktionsbausteins (22) und durch Umkehren der direkten Modelle (26).

2. Computersystem (10) nach Anspruch 1, bei dem:
- die Software-Plattform (16) weiterhin einen Vergleicher-Funktionsbaustein (20) und eine dritte assoziierte Schnittstelle (UI20) umfasst, die dem Auswählen eines Vergleichers aus einer Vielzahl von vordefinierten Vergleichern dediziert ist, wobei dieser Vergleicher-Funktionsbaustein am Ausgang den Vergleich der heterogenen Messungen (m1, m2, m3) mit der Schätzung dieser Messungen liefert, die mit Hilfe der Anwendung der direkten Modelle auf die Werte von vordefinierten Merkmalen oder Bearbeitungsparameter (a, b, c, d) erhalten wurde, und
- der Kostenberechnungs-Funktionsbaustein (22) dazu ausgelegt ist, die Kostenschätzung anhand des Ausgangs des Vergleicher-Funktionsbausteins (20) zu liefern.

3. Computersystem (10) nach Anspruch 1 oder 2, bei dem:
- der Modellierungsplatz (30) die Aufzeichnung eines direkten Metamodells (28) umfasst, das alle heterogenen Messungen (m1, m2, m3) in Abhängigkeit von allen vordefinierten Merkmalen oder Bearbeitungsparametern (a, b, c, d) und von Metamodellierungsparametern ausdrückt, und
- die Software-Plattform (16) einen Funktionsbaustein (18) zum Demultiplexen des Metamodells (28) umfasst zum Erhalten der direkten Modelle (26).

4. Computersystem (10) nach Anspruch 3, bei dem jedes direkte Modell ausschließlich mit einem einzigen Typ von Metrologievorrichtung assoziiert ist.

5. Computersystem (10) nach einem der Ansprüche 1 bis 4, bei dem Abhängigkeiten (32), die gewisse der vordefinierten Merkmale oder Bearbeitungsparameter (a, b, c, d) miteinander verbinden, in den Speichermitteln (14) aufgezeichnet sind und dazu vorgesehen sind, durch den Kostenberechnungs-Funktionsbaustein (22) oder durch den Gleichungslöser-Funktionsbaustein (24) berücksichtigt zu werden zum Optimieren der Werte von vordefinierten Merkmalen oder Bearbeitungsparametern.

6. Computersystem (10) nach einem der Ansprüche 1 bis 5, bei dem mehrere Kostenfunktionen in den Speichermitteln (14) aufgezeichnet sind, darunter:
- eine Abstandssummenfunktion, zum Beispiel unter Verwendung der Norm L1,
- eine Entropiefunktion zur Schätzung der Wahrscheinlichkeitsdichte pro Knoten,
- eine Funktion vom Typ Huber-Straffunktion,
- eine biquadratische Kostenfunktion, und
- eine Funktion vom Typ Hampel-Kostenfunktion.

7. Computersystem (10) nach einem der Ansprüche 1 bis 6, bei dem mehrere Gleichungslöser in den Speichermitteln (14) aufgezeichnet sind, darunter:
- ein Gleichungslöser zum Auflösen von algebraischen Gleichungssystemen mit mindestens einer Unbekannten,
- ein Gleichungslöser zum Auflösen durch genetischen Algorithmus,
- einen Gleichungslöser zum Auflösen durch simulierte Abkühlung,
- einen Gleichungslöser durch lokales nichtlineares Optimieren ohne Abhängigkeiten, und
- einen Gleichungslöser durch lokales nichtlineares Optimieren mit Abhängigkeiten.

8. Computersystem (10) nach einem der Ansprüche 1 bis 7, bei dem die direkten Modelle (26) definiert sind, um heterogene Messungen aus verschiedenen Typen von Metrologievorrichtungen auszudrücken, darunter:
- Messungen aus einem Raster- oder Transmissionselektronenmikroskop,
- Messungen aus einem Atomkraftmikroskop,
- Messungen, die durch Scatterometrie, Ellipsometrie, Reflektometrie oder Spektroskopie erhalten wurden,
- Messungen der Reflektivität oder Diffraktion durch Röntgenstrahlen, und
- Messungen aus einem optischen Mikroskop.

9. Verfahren zur Werteschätzung von vordefinierten Merkmalen (a, b, c, d) mikroelektronischer Vorrichtungen anhand von heterogenen Messungen (m1, m2, m3) aus verschiedenen Metrologievorrichtungen, umfassend die folgenden Schritte:
- Modellieren (100) der vordefinierten Merkmale oder von Bearbeitungsparametern der Messungen (a, b, c, d) durch Aufzeichnen von direkten Modellen (26) in Speichermitteln (14), wobei jedes direkte Modell mindestens einen Teil der heterogenen Messungen (m1, m2, m3) in Abhängigkeit von mindestens einem Teil der vordefinierten Merkmale oder Bearbeitungsparameter (a, b, c, d) und von Modellierungsparametern ausdrückt,
- Empfangen (102) der heterogenen Messungen (m1, m2, m3) durch eine Software-Plattform (16), die durch einen Prozessor (12) ausgeführt wird, der Zugriff auf die Speichermittel (14) besitzt,
- Auswählen (106) einer Kostenfunktion aus einer Vielzahl von vordefinierten Kostenfunktionen mit Hilfe einer ersten dedizierten Schnittstelle (UI22) der Software-Plattform (16),
- Auswählen (108) eines Gleichungslösers aus einer Vielzahl von vordefinierten Gleichungslösern mit Hilfe einer zweiten dedizierten Schnittstelle (UI24) der Software-Plattform (16), und
- iteratives Optimieren (110) von Werten der vordefinierten Merkmale oder Bearbeitungsparametern (a, b, c, d) durch:
• Schätzen (114, 116), durch den Prozessor (12) und mit Hilfe der ausgewählten Kostenfunktion, von Kosten durch Vergleichen der heterogenen Messungen (m1, m2, m3) mit einer Schätzung dieser Messungen, die mit Hilfe einer Anwendung der direkten Modelle (26) auf die Werte von vordefinierten Merkmalen oder Bearbeitungsparameter (a, b c, d) erhalten wurde,
• Aktualisieren (120), durch den Prozessor (12) und mit Hilfe des ausgewählten Gleichungslösers, der Werte von vordefinierten Merkmalen oder Bearbeitungsparameter (a, b, c, d) anhand der geschätzten Kosten und durch Umkehren der direkten Modelle (26).

10. Rechnerprogramm, das aus einem Kommunikationsnetzwerk herunterladbar und/oder auf einem Träger aufgezeichnet ist, der durch Rechner lesbar und/oder durch den Prozessor (12) ausführbar ist, **dadurch gekennzeichnet, dass** es Anweisungen enthält für das Ausführen der Schritte eines Verfahrens zur Werteschätzung von vordefinierten Merkmalen mikroelektronischer Vorrichtungen nach Anspruch 9, wenn das Programm auf einem Rechner ausgeführt wird.

## Claims

1. Computer system (10) for processing heterogeneous measurements (m1, m2, m3) from various metrology apparatuses with a view to estimating values of predefined features (a, b, c, d) of microelectronic devices, comprising a processor (12), storage means (14) and a software platform (16) consisting of a plurality of functional modules stored in the storage means and capable of being executed by the processor:
- wherein the storage means (14) comprise a space (30) for modeling the predefined features or measurement processing parameters (a, b, c, d) by recording direct models (26), each direct model expressing at least some of the heterogeneous measurements (m1, m2, m3) as a function of at least some of the predefined features or processing parameters (a, b, c, d) and modeling parameters,
- wherein the software platform (16) comprises a functional module (22) for calculating cost and a first associated interface (UI₂₂) dedicated to the selection of a cost function among a plurality of predefined cost functions, said functional cost calculation module providing, at the output, the estimation of a cost by comparison of the heterogeneous measurements (m1, m2, m3) with an estimation of said measurements obtained by means of an application of the direct models (26) to values of the predefined features or processing parameters (a, b, c, d),
- wherein the software platform (16) comprises a functional solver module (24) and a second associated interface (UI₂₄) dedicated to the selection of a solver among a plurality of predefined solvers, for iterative optimization by the solver of said values of the predefined features or processing parameters (a, b, c, d) based on the output of the functional cost calculation module (22) and by inversion of the direct models (26).

2. Computer system (10) according to claim 1, wherein:
- the software platform (16) also comprises a functional comparator module (20) and a third associated interface (UI₂₀) dedicated to the selection of a comparator among a plurality of predefined comparators, said functional comparator module providing, at the output, the comparison of the heterogeneous measurements (m1, m2, m3) with the estimation of said measurements obtained by means of the application of the direct models to the values of predefined features or processing parameters (a, b, c, d), and
- the functional cost calculation module (22) is designed to provide the estimation of the cost based on the output of the functional comparator module (20).

3. Computer system (10) according to claim 1 or 2, wherein:
- the modeling space (30) comprises the recording of a direct meta-model (28) expressing all of the heterogeneous measurements (m1, m2, m3) as a function of all of the predefined features or processing parameters (a, b, c, d) and meta-modeling parameters, and
- the software platform (16) comprises a functional module (18) for demultiplexing the meta-model (28) in order to obtain said direct models.

4. Computer system (10) according to claim 3, wherein each direct model is associated exclusively with a single type of metrology apparatus.

5. Computer system (10) according to any one of claims 1 to 4, wherein constraints (32) linking certain of the predefined features or processing parameters (a, b, c, d) with one another are recorded in the storage means (14) and are intended to be taken into account by the functional cost calculation module (22) or by the functional solver module (24) for optimization of said values of predefined features or processing parameters.

6. Computer system (10) according to any one of claims 1 to 5, wherein a plurality of cost functions are recorded in the storage means (14), including:
- a distance sum function, for example using L1 norm,
- an entropic function for kernel probability density estimation,
- a Huber loss type function,
- a bisquare cost function, and
- a Hampel cost type function.

7. Computer system (10) according to any one of claims 1 to 6, wherein a plurality of solvers are recorded in the storage means (14), including:
- a solver for solving systems of algebraic equations with at least one unknown,
- a genetic algorithm solution solver,
- a simulated annealing solution solver,
- a local nonlinear optimization solver without constraints, and
- a local nonlinear optimization solver with constraints.

8. Computer system (10) according to any one of claims 1 to 7, wherein the direct models (26) are defined for expressing heterogeneous measurements from various types of metrology apparatuses, including:
- measurements from a scanning or transmission electron microscope,
- measurements from an atomic force microscope,
- measurements obtained by scatterometry, ellipsometry, reflectometry or spectroscopy,
- reflectivity or diffraction X-ray measurements, and
- measurements from an optical microscope.

9. Method for estimating values of predefined features (a, b, c, d) of microelectronic devices on the basis of heterogeneous measurements (m1, m2, m3) from various metrology apparatuses, comprising the following steps:
- modeling (100) the predefined features or parameters for processing the measurements (a, b, c, d) by recording direct models (26) in storage means (14), each direct model expressing at least some of the heterogeneous measurements (m1, m2, m3) as a function of at least some of the predefined features or processing parameters (a, b, c, d) and modeling parameters,
- receiving (102) the heterogeneous measurements (m1, m2, m3), by a software platform (16) executed by a processor (12) having access to the storage means (14),
- selecting (106), by means of a first dedicated interface (UI₂₂) of the software platform (16), a cost function among a plurality of predefined cost functions,
- selecting (108), by means of a second dedicated interface (UI₂₄) of the software platform (16), a solver among a plurality of predefined solvers, and
- iterative optimization (110) of values of the predefined features or processing parameters (a, b, c, d), by:
• estimating (114, 116), by the processor (12) and by means of the cost function selected, a cost by comparison of the heterogeneous measurements (m1, m2, m3) with an estimation of said measurements obtained by means of an application of the direct models (26) to said values of predefined features or processing parameters (a, b, c, d),
• updating (120), by the processor (12) and by means of the selected solver, said values of predefined features or processing parameters (a, b, c, d) on the basis of the estimated cost and by inversion of the direct models (26).

10. Computer program downloadable from a communication network and/or recorded on a computer-readable medium and/or capable of being executed by the processor (12), **characterized in that** it includes instructions for executing steps of a method for estimating values of predefined features of microelectronic devices according to claim 9, when said program is executed on a computer.
